(19) Europäisches Patentamt
European Patent Office
Office européen des brevets

(11) **EP 4 462 423 A1**

(12) **EUROPEAN PATENT APPLICATION**

(43) Date of publication:
**13.11.2024 Bulletin 2024/46**

(21) Application number: **24169616.0**

(22) Date of filing: **11.04.2024**

(51) International Patent Classification (IPC):
***G10K 15/12*** *(2006.01)*      ***H04S 7/00*** *(2006.01)*

(52) Cooperative Patent Classification (CPC):
**G10K 15/12; H04S 7/302; H04S 7/306;**
H04R 5/033; H04S 2420/01

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **08.05.2023 US 202363500684 P**

(71) Applicant: **Nokia Technologies Oy
02610 Espoo (FI)**

(72) Inventors:
• **ERONEN, Antti Johannes
Tampere (FI)**
• **MCCREA, Michael Thomas
Helsinki (FI)**
• **POLITIS, Archontis
Tampere (FI)**

(74) Representative: **Nokia EPO representatives
Nokia Technologies Oy
Karakaari 7
02610 Espoo (FI)**

(54) **RENDERING OF REVERBERATION WITH STARTUP CONTROL**

(57) A method for applying reverberation to at least one audio signal, the method comprising: obtaining the at least one audio signal; obtaining at least one reverberation parameter; controlling a digital reverberator based on the at least one reverberation parameter; providing at least one control line comprising a delay line and a gain filter, the at least one control line using the at least one reverberation parameter to generate an output from the at least one control line; and generating at least one reverberated audio signal based on at least one output of the at least one digital reverberator and the generated output from the at least one control line, wherein at least a portion of late reverberation in the generated at least one reverberated audio signal interfering with at least one reflection echo is substantially attenuated.

**EP 4 462 423 A1**

**Description**

<u>Field</u>

The present application relates to apparatus and methods for rendering of reverberation with startup control, but not exclusively for rendering of reverberation with startup control in augmented reality and/or virtual reality apparatus.

<u>Background</u>

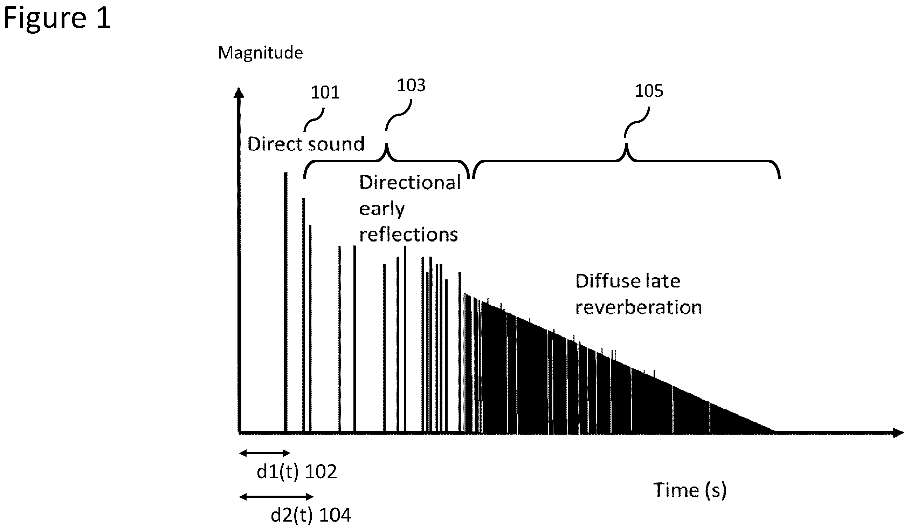

Reverberation refers to the persistence of sound in a space after the actual sound source has stopped. Different spaces are characterized by different reverberation characteristics. For conveying spatial impression of an environment, reproducing reverberation perceptually accurately is important. Room acoustics are often modelled with individually synthesized early reflection portion and a statistical model for the diffuse late reverberation. Figure 1 depicts an example of a synthesized room impulse response where the direct sound 101 is followed by discrete early reflections 103 (or reflection echoes) which have a direction of arrival (DOA) and diffuse late reverberation 105 which can be synthesized without any specific direction of arrival. The delay $d1(t)$ 102 in Figure 1 can be seen to denote the direct sound arrival delay from the source to the listener and the delay $d2(t)$ 104 can denote the delay from the source to the listener for one of the early reflections (in this case the first arriving reflection).

One method of reproducing reverberation is to utilize a set of $D$ loudspeakers (or virtual loudspeakers reproduced binaurally using a set of head-related transfer functions (HRTF)). The loudspeakers are positioned around the listener somewhat evenly. Mutually incoherent reverberant signals are reproduced from these loudspeakers, producing a perception of surrounding diffuse reverberation.

The reverberation produced by the different loudspeakers has to be mutually incoherent. In a simple case the reverberations can be produced using the different channels of the same reverberator, where the output channels are uncorrelated but otherwise share the same acoustic characteristics such as reverberation time and level (specifically, the diffuse-to-direct ratio or reverberant-to-direct ratio or diffuse-to-total ratio or diffuse-to-source ratio or any other suitable parameter for representing reverberation energy or level). Such uncorrelated outputs sharing the same acoustic characteristics can be obtained, for example, from the output taps of a feedback delay network (FDN) reverberator with suitable tuning of the delay line lengths and mixing matrix, or from a reverberator based on using decaying uncorrelated noise sequences by using a different uncorrelated noise sequence in each channel. In this case, the different reverberant signals effectively have the same features, and the reverberation is typically perceived to be similar in all directions.

<u>Summary</u>

There is provided according to a first aspect a method for applying reverberation to at least one audio signal, the method comprising: obtaining the at least one audio signal; obtaining at least one reverberation parameter; controlling a digital reverberator based on the at least one reverberation parameter; providing at least one control line comprising a delay line and a gain filter, the at least one control line using the at least one reverberation parameter to generate an output from the at least one control line; and generating at least one reverberated audio signal based on at least one output of the at least one digital reverberator and the generated output from the at least one control line, wherein at least a portion of late reverberation in the generated at least one reverberated audio signal interfering with at least one reflection echo is substantially attenuated.

Obtaining at least one reverberation parameter may comprise obtaining at least one reverberation time.

Controlling the digital reverberator based on the at least one reverberation parameter may comprise applying the at least one delay line to the at least one audio signal to generate at least two echoes.

Providing at least one control line may comprise providing at least one control echo.

Generating at least one reverberated audio signal based on the at least one output of the at least one digital reverberator and the generated output from the at least one control line may comprise generating the at least one reverberated audio signal based on a combination of at least one audio signal containing the at least two echoes from the at least one output of the digital reverberator and at least one audio signal containing the at least one control echo from the at least one output of the at least one control line respectively.

Generating at least one reverberated audio signal based on the at least one output of the at least one digital reverberator and the generated output from the at least one control line may comprise providing the at least one control echo to at least partially suppress a first echo of the at least two echoes such that the at least one reverberated audio signal comprises reverberations which do not interfere with the at least one reflection echoes.

The at least one reflection echoes are separately rendered early reflections.

Obtaining at least one reverberation parameter may comprise obtaining the at least one reverberation parameter based on at least one dimension parameter associated with a virtual acoustic space within which the audio signal is being rendered.

Controlling a digital reverberator based on the at least one reverberation parameter may comprise controlling at least one feedback attenuation filter.

Controlling a digital reverberator based on the at least one reverberation parameter may comprise controlling a feedback matrix configured to feedback at least one output of the digital reverberator to at least one input of the digital reverberator.

The at least one control line may be a first number of control lines and the digital reverberator may comprise a second number of delay lines.

The first number may be less than or equal to the second number.

The at least a portion of late reverberation may be at least an early portion of the late reverberation.

According to a second aspect there is provided an apparatus for applying reverberation to at least one audio signal, the apparatus comprising at least one processor and at least one memory storing instructions that, when executed by the at least one processor, cause the system at least to perform: obtaining the at least one audio signal; obtaining at least one reverberation parameter; controlling a digital reverberator based on the at least one reverberation parameter; providing at least one control line comprising a delay line and a gain filter, the at least one control line using the at least one reverberation parameter to generate an output from the at least one control line; and generating at least one reverberated audio signal based on at least one output of the at least one digital reverberator and the generated output from the at least one control line, wherein at least a portion of late reverberation in the generated at least one reverberated audio signal interfering with at least one reflection echo is substantially attenuated.

The apparatus caused to perform obtaining at least one reverberation parameter may be further configured to perform obtaining at least one reverberation time.

The apparatus caused to perform controlling the digital reverberator based on the at least one reverberation parameter may be configured to perform applying the at least one delay line to the at least one audio signal to generate at least two echoes.

The apparatus caused to perform providing at least one control line may be further configured to perform providing at least one control echo.

The apparatus caused to perform generating at least one reverberated audio signal based on the at least one output of the at least one digital reverberator and the generated output from the at least one control line may be further configured to perform generating the at least one reverberated audio signal based on a combination of at least one audio signal containing the at least two echoes from the at least one output of the digital reverberator and at least one audio signal containing the at least one control echo from the at least one output of the at least one control line respectively.

The apparatus caused to perform generating at least one reverberated audio signal based on the at least one output of the at least one digital reverberator and the generated output from the at least one control line may be configured to perform providing the at least one control echo to at least partially suppress a first echo of the at least two echoes such that the at least one reverberated audio signal comprises reverberations which do not interfere with separately-rendered early reflections.

The apparatus caused to perform obtaining at least one reverberation parameter may be further configured to perform obtaining the at least one reverberation parameter based on at least one dimension parameter associated with a virtual acoustic space within which the audio signal is being rendered.

The apparatus caused to perform controlling a digital reverberator based on the at least one reverberation parameter may be configured to perform controlling at least one feedback attenuation filter.

The apparatus caused to perform controlling a digital reverberator based on the at least one reverberation parameter may be configured to perform controlling a feedback matrix configured to feedback at least one output of the digital reverberator to at least one input of the digital reverberator.

The at least one control line is a first number of control lines and the digital reverberator may comprise a second number of delay lines.

The first number may be less than or equal to the second number.

The at least a portion of late reverberation may be at least an early portion of the late reverberation.

According to a third aspect there is provided an apparatus for applying reverberation to at least one audio signal, the apparatus comprising means configured to: obtain the at least one audio signal; obtain at least one reverberation parameter; control a digital reverberator based on the at least one reverberation parameter; provide at least one control line comprising a delay line and a gain filter, the at least one control line using the at least one reverberation parameter to generate an output from the at least one control line; and generate at least one reverberated audio signal based on at least one output of the at least one digital reverberator and the generated output from the at least one control line, wherein at least a portion of late reverberation in the generated at least one reverberated audio signal interfering with at least one reflection echo is substantially attenuated.

The means configured to obtain at least one reverberation parameter may be configured to obtain at least one reverberation time.

The means configured to control the digital reverberator based on the at least one reverberation parameter may be configured to apply the at least one delay line to the at least one audio signal to generate at least two echoes.

The means configured to provide at least one control line may be configured to provide at least one control echo.

The means configured to generate at least one reverberated audio signal based on the at least one output of the at least one digital reverberator and the generated output from the at least one control line may be configured to generate the at least one reverberated audio signal based on a combination of at least one audio signal containing the at least two echoes from the at least one output of the digital reverberator and at least one audio signal containing the at least one control echo from the at least one output of the at least one control line respectively.

The means configured to generate at least one reverberated audio signal based on the at least one output of the at least one digital reverberator and the generated output from the at least one control line may be configured to provide the at least one control echo to at least partially suppress a first echo of the at least two echoes such that the at least one reverberated audio signal comprises reverberations which do not interfere with the at least one reflection echoes.

The at least one reflection echoes are separately rendered early reflections.

The means configured to obtain at least one reverberation parameter may be configured to obtain the at least one reverberation parameter based on at least one dimension parameter associated with a virtual acoustic space within which the audio signal is being rendered.

The means configured to control a digital reverberator based on the at least one reverberation parameter may be configured to control at least one feedback attenuation filter.

The means configured to control a digital reverberator based on the at least one reverberation parameter may be configured to control a feedback matrix configured to feedback at least one output of the digital reverberator to at least one input of the digital reverberator.

The at least one control line may be a first number of control lines and the digital reverberator may comprise a second number of delay lines.

The first number may be less than or equal to the second number.

The at least a portion of late reverberation may be at least an early portion of the late reverberation.

According to a fourth aspect there is provided an apparatus for applying reverberation to at least one audio signal, the apparatus comprising: obtaining circuitry configured to obtain the at least one audio signal; obtaining circuitry configured to obtain at least one reverberation parameter; controlling circuitry configured to control a digital reverberator based on the at least one reverberation parameter; provide at least one control line comprising a delay line and a gain filter, the at least one control line using the at least one reverberation parameter to generate an output from the at least one control line; and generate at least one reverberated audio signal based on at least one output of the at least one digital reverberator and the generated output from the at least one control line, wherein at least a portion of late reverberation in the generated at least one reverberated audio signal interfering with at least one reflection echo is substantially attenuated.

According to a fifth aspect there is provided a computer program comprising instructions [or a computer readable medium comprising instructions] for causing an apparatus, for applying reverberation to at least one audio signal, the apparatus caused to perform at least the following: obtaining the at least one audio signal; obtaining at least one reverberation parameter; controlling a digital reverberator based on the at least one reverberation parameter; providing at least one control line comprising a delay line and a gain filter, the at least one control line using the at least one reverberation parameter to generate an output from the at least one control line; and generating at least one reverberated audio signal based on at least one output of the at least one digital reverberator and the generated output from the at least one control line, wherein at least a portion of late reverberation in the generated at least one reverberated audio signal interfering with the at least one reflection echo is substantially attenuated.

According to a sixth aspect there is provided a non-transitory computer readable medium comprising program instructions for causing an apparatus, for applying reverberation to at least one audio signal, to perform at least the following: obtaining the at least one audio signal; obtaining at least one reverberation parameter; controlling a digital reverberator based on the at least one reverberation parameter; providing at least one control line comprising a delay line and a gain filter, the at least one control line using the at least one reverberation parameter to generate an output from the at least one control line; and generating at least one reverberated audio signal based on at least one output of the at least one digital reverberator and the generated output from the at least one control line, wherein at least a portion of late reverberation in the generated at least one reverberated audio signal interfering with at least one reflection echo is substantially attenuated.

According to a seventh aspect there is provided an apparatus, for applying reverberation to at least one audio signal, comprising: means for obtaining the at least one audio signal; means for obtaining at least one reverberation parameter; means for controlling a digital reverberator based on the at least one reverberation parameter; means for providing at least one control line comprising a delay line and a gain filter, the at least one control line using the at least one reverberation parameter to generate an output from the at least one control line; and means for generating at least one reverberated audio signal based on at least one output of the at least one digital reverberator and the generated output from the at least one control line, wherein at least a portion of late reverberation in the generated at least one reverberated audio signal interfering with at least one reflection echo is substantially attenuated.

According to an eighth aspect there is provided a computer readable medium comprising instructions for causing an apparatus, for applying reverberation to at least one audio signal, to perform at least the following: obtaining the at least one audio signal; obtaining at least one reverberation parameter; controlling a digital reverberator based on the at least one reverberation parameter; providing at least one control line comprising a delay line and a gain filter, the at least one control line using the at least one reverberation parameter to generate an output from the at least one control line; and generating at least one reverberated audio signal based on at least one output of the at least one digital reverberator and the generated output from the at least one control line, wherein at least a portion of late reverberation in the generated at least one reverberated audio signal interfering with at least one reflection echo is substantially attenuated.

An apparatus comprising means for performing the actions of the method as described above.

An apparatus configured to perform the actions of the method as described above.

A computer program comprising program instructions for causing a computer to perform the method as described above.

A computer program product stored on a medium may cause an apparatus to perform the method as described herein.

An electronic device may comprise apparatus as described herein.

A chipset may comprise apparatus as described herein.

Embodiments of the present application aim to address problems associated with the state of the art.

Summary of the Figures

For a better understanding of the present application, reference will now be made by way of example to the accompanying drawings in which:

Figure 1 shows a model of room acoustics with regard to the room impulse response;
Figure 2 shows schematically an example apparatus within which some embodiments may be implemented;
Figure 3 shows a flow diagram of the operation of the example apparatus as shown in Figure 2 with respect to reverberant audio signal rendering;
Figure 4 shows schematically a reverberator which includes an example feedback delay network (FDN) with startup control as shown in Figure 2 in further detail according to some embodiments;
Figure 5 shows schematically an example reverberator parameter determiner as shown in Figure 2 in further detail according to some embodiments;
Figure 6 shows a flow diagram of the operation of the example reverberator parameter determiner as shown in Figure 5;
Figure 7 shows schematically an example binaural renderer as shown in Figure 2 in further detail according to some embodiments;
Figure 8 shows a flow diagram of the operation of the example binaural renderer as shown in Figure 7;
Figure 9 shows schematically an example early reflection processor and renderer as shown in Figure 2 according to some embodiments;
Figure 10 shows an example showing early reflections processing;
Figure 11 shows an example system within which some embodiments can be implemented; and
Figure 12 shows an example device suitable for implementing the apparatus shown in previous figures.

Embodiments of the Application

The following describes in further detail suitable apparatus and possible mechanisms for controlling startup behavior parameterizing and rendering audio scenes with diffuse reverberation.

In a virtual acoustics rendering system, reverberation is typically rendered as a combination of a certain number of distinct early reflections (or reflection echoes) and a stochastic model for the late reverberation. The early reflection synthesis is thus typically position-dependent in that it varies with source and listener positions, while the late reverberation synthesis is not. Together these two can create a plausible reverberation rendering for a physical or virtual space. The reverberation rendering is combined (summed) with direct sound rendering, which involves distance gain attenuation, air absorption filtering, and directional reproduction (binaural or loudspeaker) of the direct sound component that directly propagates to the ears of the listener without reflecting or reverberating in the space.

To produce a good quality reverberation output the late reverberation is configured such that the transition from the early reflections to the late reverberation is perceived as smooth and continuous, without noticeable gaps or energy fluctuation. The rendering is implemented by constructing the impulse responses offline (or as a background process) then the part of the impulse response corresponding to the late part can be processed to ensure it fits well with the early reflections.

However, when rendering is performed without offline creation of impulse responses using, for example, digital reverberators then such offline processing of the impulse responses is not possible since impulse responses may not be available in the system. An example of such a system uses a geometric model to produce early reflections and a feedback delay network (FDN) digital reverberator to produce the late reverberation.

It has been suggested that a second FDN with a shorter reverberation time is used to filter the input signal generating a second reverberant signal which can then be inverted in phase relative to the primary FDN and added to the output signal of the primary FDN to achieve suppression (or control) of the early echoes (or pulses if referring to an impulse response) produced by the primary FDN and to reduce their interference with separately-rendered early reflections. However, this can be computationally complex as it requires running two complete FDNs in parallel (and therefore requires double the number of calculations compared to a single FDN). Moreover, such suggested methods can be difficult to configure as they require two complete sets of reverberator parameters to be used for configuration.

The concept as discussed with respect to the examples and embodiments hereafter in further detail is one of controlling the startup behavior of a reverberator's feedback network (FN) but with a lower computational complexity than two concurrent FNs, as in the previous double-FDN example, and which aims to be straightforward to configure and to achieve an improved interaction between late reverberation and synthesized early reflections.

Such examples selectively suppress first (early) echoes from a FN thereby producing fixed-delay early echoes of a FN which interfere less with synthesized (variable-delay, position-dependent) early reflections. Implementing such a suppression of first echoes can be considered to achieve a desired fade-in behavior or startup control of the reverberator.

With respect to the reverberator and the reflection processor these are configured to generate audio signals associated with echoes within the system. For example, the (early) reflection processor is configured to produce a discrete number of echoes which are specular with regard to features and geometry of the modelled room and are correspondingly precise and varied in their arrival direction, intensity, and coloration. The echoes produced by the (early) reflection processor are accordingly referred to as reflection echoes hereafter. The reflection processor is external to and running in parallel with the (late) reverberator which is configured to produce late reverberation.

The (late) reverberator is configured to produce, by way of a feedback network, a decaying stream of many echoes which increase in number (density) while decreasing in intensity (loudness) over time. This can be implemented by the feedback aspect where the input audio signal passes through the network, splitting into numerous "echoes", all of which subsequently recirculate through the same network again, each splitting into more echoes, and so on. These echoes have only a loose correspondence to the geometry of the room, so do not represent geometrically precise (specular) reflections.

Although the earlier and following discussions refers the FN being configured to generate 'early' echoes, the term 'early' describes a perceptual distinction between the sparse echoes in the early response of the reverberator and the more dense, diffuse echoes that result from the feedback process and which define the later response of the reverberator. As such the FN is configured to generate a series of (for example at least two succeeding) echoes which are perceptually distinguishable as individual echoes and are early in the response of the reverberator.

Typically, early echoes may refer to echoes produced by, for example, one to five passes through the FN's feedback loop and up to a certain transition time. However, with respect to the following embodiments the early echoes suppressed are those generated from the first pass through the delay lines and feedback attenuation filters of the FN, prior to recirculating, and are specifically referred to as first echoes or first (early) echoes. By contrast, the echoes resulting from successive passes through the FN are referred to as early echoes, up to a transition time after which further cycles through the FN produce perceptually indistinguishable echoes called late echoes, diffuse tail, late reverberation, or similar. In addition to the various early echoes generated by the reverberator, so-called reflection echoes are generated by an (early) reflection processor which is external to, and runs in parallel with, the reverberator.

Thus, in summary, the concept which is defined further with respect to the following embodiments is one which relates to reproduction of (late) reverberation where apparatus and methods are proposed that enable control of the startup behavior of a digital reverberator such that the early stage of the rendered late reverberation interferes less with separately-rendered reflection echoes. The result is an improved virtual acoustics rendering for physical or virtual rooms where the early reflections blend well with diffuse late reverberation. This can be achieved in some embodiments by:

> obtaining reverberation parameters containing at least a reverberation time;
> configuring a digital reverberator according to the reverberation parameters;
> configuring a first echo suppressor, which includes at least one control delay line and at least one control line gain filter, using the reverberator parameters;
> producing an output from the first echo suppressor using at least one input signal; and

rendering a reverberated signal using the reverberator and the at least one input signal while using the output of the first echo suppressor to control the startup behavior of the reverberator to achieve late reverberation which minimizes interference with separately-rendered early reflections.

In some embodiments, the feedback network (FN) of the reverberator is a feedback delay network (FDN) that produces 15 output channels. The output channels can be related to 15 spatial directions surrounding the listener. The outputs of the reverberator can be reproduced with (virtual or real) loudspeakers in the corresponding directions.

In some embodiments, a desired reverberation time (RT60) parameter is estimated. Then, the delay line attenuation filters of the FN are adjusted using the RT60 parameter and at least one dimension parameter associated with the room.

Furthermore, in some embodiments, control delay lines are adjusted to have the same lengths of the FN delay lines. The number of the control delay lines does not need to be equal to the number of delay lines of the FN. There can be fewer control delay lines if not all echoes corresponding to all first (early) echoes of all FN delay lines need to be suppressed or controlled. Furthermore, in some embodiments control line gain filters can be added to each control delay line to achieve the desired startup control behavior. The functional pairing of a control delay line with a subsequent control line gain filter will be designated as a control line. The first echo suppressor comprises one or more control lines.

Furthermore in some embodiments the input audio signal can be reverberated using the FN. The input audio signal can also be fed into the control delay lines of the first echo suppressor. The outputs from the first echo suppressor can furthermore be combined (summed) with the FN outputs. In doing so, the first echoes of the FN are effectively suppressed.

In addition, in some embodiments, (early) reflection echoes are separately rendered using, for example, the image source model. The reflection echoes are synthesized using a tapped delay line and absorption filtering. The synthesized reflection echo signals are then combined with the synthesized late reverberation signals in which first echoes have been suppressed.

Therefore, the early reflections are perceived predominantly by the early reflection echo rendering path, while the late, diffuse reverberation is perceived by the reverberator rendering path. The resulting reverberation is perceived to vary depending on listener position on account of there being less interference between the reflection echoes and the onset of the late reverberation. An interference is when two signals interfere or overlap (or nearly overlap) in time. The interference caused a reduction of the perceptual salience of the more important signal which is the reflection echoes in this situation. By reducing the interference, as discussed in these embodiments, the perception of the reflection echoes is increased by the reduction of the interference.

In some embodiments as an output, there are 15 mutually (almost) incoherent reverberant signals. The output signals can then be reproduced using loudspeakers (or alternatively virtual loudspeakers that are convolved with HRTFs or yet alternatively encoded to ambisonics which is then decoded to a binaural or loudspeaker format) that are positioned in the directions corresponding to the spatial directions used above and the levels of which are controlled with channel gain coefficients.

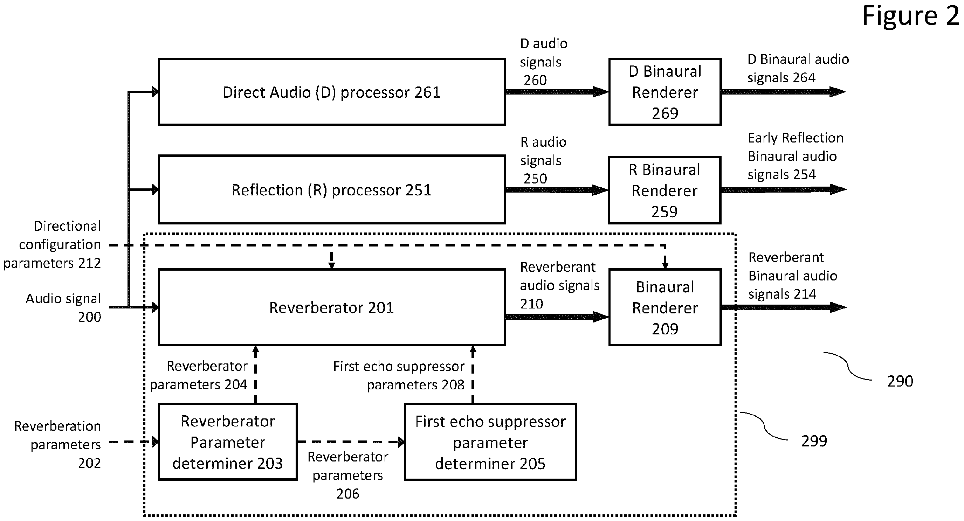

Figure 2 shows an example system or apparatus 299 suitable for implementing embodiments of the present invention within a direct, early reflection and later reverberation audio signal processing system 290. The system comprises inputs such as audio signal 200, reverberation parameters 202, and directional configuration parameters 212. The system or apparatus 299 further is configured to render reverberant binaural signals 214 as an output, containing late reverberation which are perceived according to the acoustic parameters carried in the reverberation parameters 202.

In some embodiments the reverberation parameters 202 comprises suitable (non-directional) parameters for configuring the reverberator 201. Suitable reverberation parameters 202 include, for example, the reverberation times $T_{60}(k)$ in frequency bands (where $k$ is the frequency band index), reverberant-to-direct ratio $RDR(k)$ in frequency bands, the pre-delay $t_{pre}$, and room dimensions. Alternatively to the RDR, the diffuse-to-source energy ratio (DSR) can be used. The reverberation parameters 202 can, for example, be obtained from a bitstream or from a listening space description format (LSDF) input to the renderer.

The directional configuration parameters 212 can indicate encoding directions used to render the reverberation by a suitable rendering scheme that creates a perception of enveloping diffuse reverberation, such as ambisonic or amplitude panning rendering, or simply rendered directly to a surrounding (real or virtual) loudspeaker setup. As an example, the following directional configuration can be used:

Azimuth $\theta_{ls}(d)$: 90, -90, 114, -60, 85, -130, 49, -67, 154, -48, 19, -162, 151, -9, 180 degrees.
Elevation $\phi_{ls}(d)$: 0, 0, 20, -6, -44, -21, 41, 52, -9, -55, -31, 21, 73, 20, 63 degrees.

The index d corresponds to the output channel of the reverberator 201.

In some embodiments the system 299 comprises a reverberator parameter determiner 203 configured to obtain the reverberation parameters 202 such as $T_{60}(k)$, $RDR(k)$, and $t_{pre}$ and convert these into suitable reverberator parameters 204 for the reverberator 201 and to the first echo suppressor parameter determiner 205.

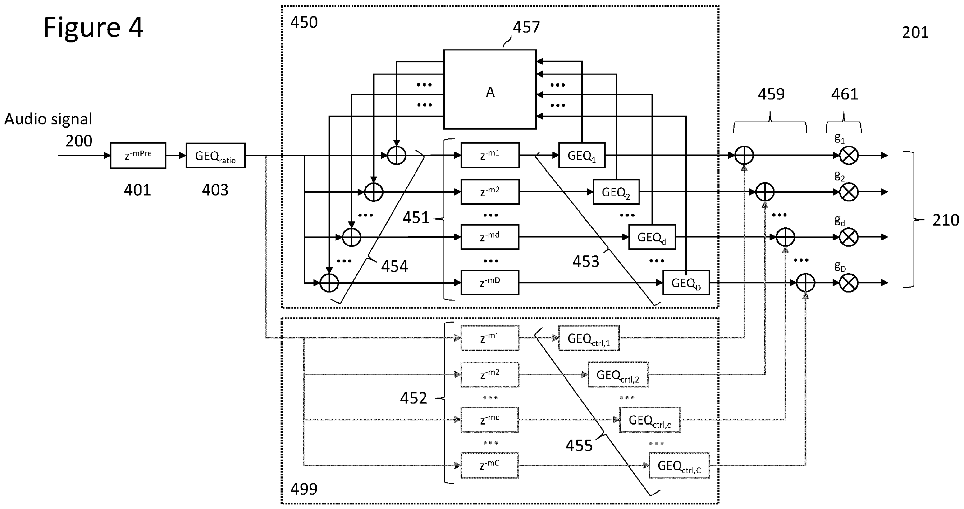

Furthermore, the system 299 comprises a first echo suppressor parameter determiner 205 configured to receive the reverberator parameters 206 and generate first echo suppressor parameters 208 which are used to configure the first echo suppressor 499 of the reverberator to attenuate first (early) echoes from the output of the feedback network 450 of Figure 4 of the reverberator.

In some embodiments the system 299 comprises a reverberator 201 configured to receive the audio signal 200 $s_{in}(t)$, where $t$ is the sample (time) index. Furthermore, the reverberator 201 is configured to receive the reverberator parameters 204 and the first echo suppressor parameters 208. In some embodiments the reverberator 201 is further configured to receive the directional configuration (and the room dimensions) 212 that may be used to configure the reverberation.

The reverberator 201 is shown herein using a feedback network (FN) implemented as a feedback delay network (FDN) but in other embodiments the FN can be implemented using other suitable feedback architectures.

In this example embodiment, the reverberator 201 has $D$ = 15 output channels indexed with d = 1, 2, ..., d, ..., D. The resulting reverberant audio signals 210 $s_{rev}(t, d)$ are mutually incoherent, and they have acoustical characteristics according to the reverberator parameters 204 and the first (early) echoes are suppressed (cancelled or otherwise attenuated) according to the first echo suppressor parameters 208.

In some embodiments the system 299 comprises a binaural renderer 209. The reverberant audio signals 210 $s_{rev}(t, d)$ are forwarded to the binaural renderer 209, which also receives directional configuration parameters 212 as further inputs. The binaural renderer 209 in some embodiments is configured to render the reverberated audio signals to reverberant binaural signals 214 $s_{bin}(t, i)$ (where $i$ = 1, 2 is the binaural channel index), which can, for example, be reproduced using headphones. These signals are perceived as surrounding and enveloping with acoustical characteristics according to reverberation parameters 202.

The direct, reflection and late reverberation audio signal processing system 290 can furthermore comprise a reflection R (or early reflection ER) processor 251 configured to receive the audio signal 200 and generate reflection audio signals 250 which are passed to a R binaural renderer 259.

The direct, reflection and late reverberation audio signal processing system 290 can furthermore comprise a reflection R (or early reflection ER) binaural renderer 259 configured to receive the reflection audio signals 250 and generate early reflection binaural audio signals 254 which are output.

Furthermore, the direct, reflection and late reverberation audio signal processing system 290 can comprise a direct audio (D) processor 261 configured to receive the audio signal 200 and generate direct audio signals 260 which are passed to a direct audio binaural renderer 269. The direct audio (D) processor 261 renders the portion of the sound that directly reaches the listener without reflecting or reverberating. It applies distance gain attenuation (e.g., attenuation proportional to 1/$distance$ where $distance$ is the distance from the sound source to the listener) and air absorption filtering (which is a distance-dependent low-pass filter attenuating high frequencies).

The direct, reflection and late reverberation audio signal processing system 290 can furthermore comprise a direct audio binaural renderer 269 configured to receive the direct (D) audio signals 260 and generate direct audio binaural audio signals 264 which are output.

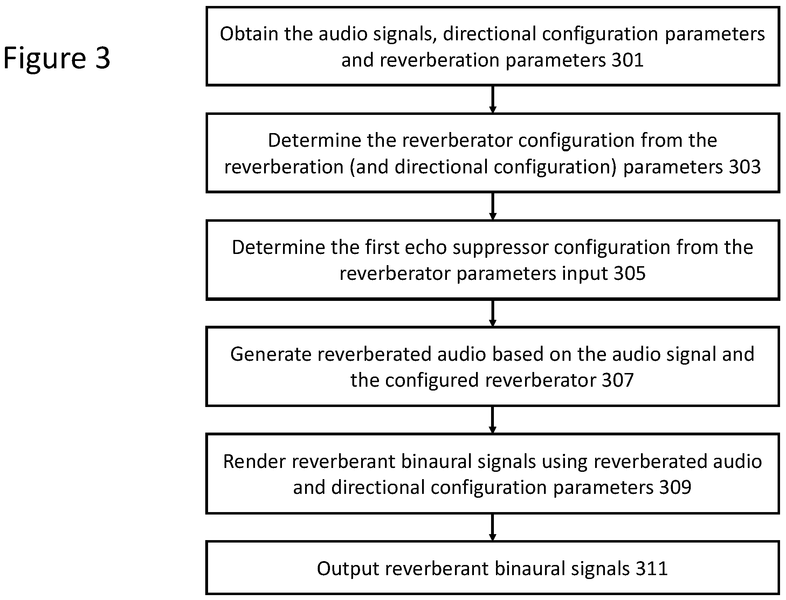

Figure 3 shows an example flow diagram of the operations of the system shown in Figure 2 with respect to the reverberator and binaural renderer associated with the reverberator.

First there is obtained the audio signals, directional configuration parameters and reverberation parameters as shown by 301.

Then there is the operation of determining reverberator configuration from the reverberation parameters input and optionally the directional configuration as shown by 303.

Additionally, there is the operation of determining control delay line and control line gain filter parameters to configure the first echo suppressor of the reverberator from the reverberator parameters input as shown by 305.

Then reverberated audio signals are generated based on the audio signal and the configured reverberator as shown by 307.

Then reverberant binaural signals are rendered using the reverberated audio signals and directional configuration parameters as shown by 309.

Then reverberant binaural signals are output as shown by 311.

Figure 4 shows in further detail the reverberator 201 introduced in Figure 2. As discussed above the reverberator 201 can be used to produce $D$ uncorrelated outputs. In some embodiments the reverberator 201 is configured to produce 15 outputs which are subsequently encoded to be rendered from different spatial directions defined by the directional configuration.

In some embodiments the reverberator 201 comprises a pre-delay line $z^{-m_{pre}}$ 401, configured to receive and delay the input audio signal. The reverberator 201 also comprises a reverberation ratio control filter $GEQ_{ratio}$ 403 which is configured to receive the pre-delay line output. The reverberator 201 further comprises a number $D$ of feedback delay lines $z^{-m_d}$ 451 and corresponding feedback delay line attenuation filters $GEQ_d$ 453. The signals which are output from GEQ$_d$ 453 are sent to inputs of a feedback matrix *A* 457. *D* signal combiners 454 (adders) sum the outputs of the feedback matrix *A* 457 with the output of GEQ$_{ratio}$ 403 to be used as inputs to each of the feedback delay lines $z^{-md}$ 451. The reverberator further comprises *C* signal combiners 459 which combine the outputs of feedback delay line attenuation filters GEQ$_d$ 453 with the outputs of the first echo suppressor 499 (discussed later). The outputs of signal combiners 459 (or, in the case that *C* < *D*, outputs of delay line attenuation filters GEQ$_d$ 453 which are not routed to a signal combiner 459) are routed to D signal multipliers 461 which in turn output the reverberant audio signals 210.

Thus, in some embodiments the reverberator 201 is configured to receive reverberator parameters which comprise a delay length $m_{pre}$, in samples, for pre-delay line $z^{-mpre}$ 401, coefficients of a reverberation ratio control filter GEQ$_{ratio}$ 403, delay lengths $m_d$ for each of *D* feedback delay lines $z^{-md}$ 451, coefficients for each of *D* feedback delay line attenuation filters GEQ$_d$ 453, and coefficients for the feedback matrix *A* 457. The reverberator parameters also comprise output channel gains $g_d$ which are used to configure *D* signal multipliers 461.

In some embodiments the attenuation filter GEQ$_d$ is a graphic equalizer (EQ) filter using *M* biquad IIR band filters. In the case of octave-band filtering, *M* = 10. Thus, the reverberator parameters corresponding to each graphic EQ filter comprise the feedforward and feedback coefficients for 10 biquad IIR filters, the gains for biquad band filters, and the overall gain. The feedback delay lines $z^{-md}$ 451 can also be referred as loop delay lines or recirculating delay lines and the feedback delay line attenuation filters GEQ$_d$ 453 can be referred to as loop filters or recirculating filters. In some embodiments the coefficients of feedback matrix A 457 are hardcoded in software code rather than provided as parameters.

The reverberator thus comprises multiple recirculating delay lines associated with the feedback network (FN) 450. The feedback matrix A 457 is used to control the recirculation gain and routing within the network. The feedback delay line attenuation filters GEQ$_d$ 453 can be implemented in some embodiments as graphic EQ filters implemented as cascades of second-order section IIR filters and can facilitate controlling the energy decay rate at different frequencies. The feedback delay line attenuation filters GEQ$_d$ 453 furthermore are designed such that they attenuate the signal by the desired amount with each pass through the FN such that the desired reverberation time (RT60) is achieved.

The reverberator furthermore comprises a first echo suppressor 499. The first echo suppressor 499 comprises C control lines which each comprise a control delay lines $z^{-mc}$ 452 in series with a control line attenuation filters GEQ$_{ctrl,c}$ 455, depicted in grey in Figure 4. The echoes produced by the control lines of the first echo suppressor are designated as control echoes, each of which suppress a first echo from the FN. The first echoes are the signals which have passed through the feedback delay line 451 and feedback delay line attenuation filters 453 only once and have not yet recirculated via the feedback matrix A 457.

The control delay line lengths $m_c$, where c = 1, 2, ..., c, ... *C,* have the same lengths as those of the feedback delay lines in the FN whose corresponding output channels carry the first echoes to be suppressed. The control line attenuation filters GEQ$_{ctrl,c}$ 455 are designed and configured such that, when their output signals are combined with the output signals from the feedback delay line attenuation filters GEQ$_d$ 453, the first echoes from the FN are suppressed to a desired level. Due to the configuration of the control delay lines $z^{-mc}$ 452 and control line attenuation filters GEQ$_{ctrl,c}$ 455, the control echoes from the first echo suppressor are coincident in time with the corresponding first echoes of the FN to be suppressed. The output signals from the control lines are routed to signal combiners 459 which are configured to combine them with corresponding outputs from FN.

In the example, the number *C* of control delay lines 452 is the same as the number *D* of recirculating delay lines in the FN. However, in some embodiments *C* < *D,* or otherwise *C* need not equal *D.* For example, the first three control delay lines *c* = 1, 2, 3, could be used to suppress first echoes associated with the FN delay lines identified by the indices *d* = 1, 4, 6.

The control delay lines 452 are noncirculating delay lines (thus there is no feedback loop) whereas feedback delay lines 451 recirculate through the feedback loops and their outputs go through the feedback matrix A 457.

The number of delay lines *D* (and the control delay lines *C*) can be adjusted depending on quality requirements and the desired tradeoff between reverberation quality and computational complexity. In an embodiment, an efficient implementation with *D* = 15 delay lines is used. This makes it possible to define the coefficients of the feedback matrix A 457 as proposed by Rocchesso in Maximally Diffusive Yet Efficient Feedback Delay Networks for Artificial Reverberation, IEEE Signal Processing Letters, Vol. 4. No. 9, Sep 1997, in terms of a Galois sequence facilitating efficient implementation.

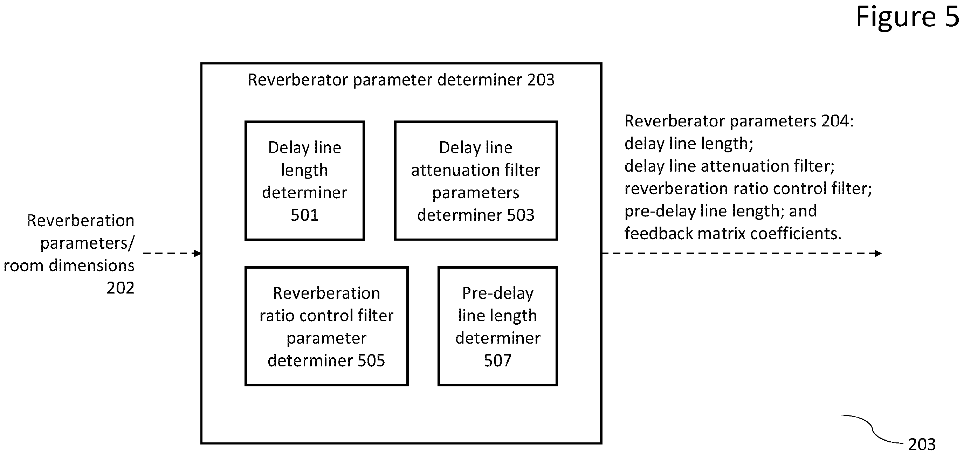

Figure 5 shows an example reverberator parameter determiner 203. The reverberator parameter determiner 203 in some embodiments is configured to obtain the reverberation parameters (and room dimensions) 202 and generate suitable reverberator parameters 204, such as: delay line length; delay line attenuation filter; reverberation ratio control filter; pre-delay line length; and feedback matrix coefficients.

For example, the reverberator parameter determiner 203 comprises a delay line length determiner 501 which can be configured to determine delay line lengths $m_d$ for each of *D* delay lines based on virtual room dimensions. Here, we use the dimensions of the enclosure, that is, a bounding box that encloses or is aligned with the walls of the physical or virtual room. For example, a shoebox shaped room can be defined with dimensions *xDim, yDim, zDim.* If the room is not shaped as a shoebox (or cuboid) then a shoebox can be fit inside the room and the dimensions of the fitted shoebox can be utilized for the delay line lengths. Alternatively, the dimensions can be obtained as three longest orthogonal dimensions in the non-shoebox shaped room, or by another suitable method. Such dimensions can also be obtained from a mesh if the bounding box is provided as a mesh. The dimensions can further be converted to modified dimensions of a virtual room or enclosure having the same volume as the input room or enclosure. For example, the ratios 1, 1.3, and 1.9 can be used for the converted virtual room dimensions. When the method is executed in the renderer then the enclosure vertices are obtained from the bitstream and the dimensions can be calculated, along each of the axes x,y,z, by the difference of the maximum and minimum value of the vertices.

The delays can in some embodiments be set proportionally to standing wave resonance frequencies in the virtual room or physical room. The delays can thus be set proportionally to standing wave resonance frequencies in the virtual room or physical room (the acoustic environment).

The delay line lengths $m_d$ can further be made to be mutually prime integers. This choice minimizes coherent repetition in the impulse response of the FN. The sieve of the Sundaram algorithm can be used to find the prime numbers up to the maximum delay line length. Each delay line length can then be mapped to the closest prime number in the obtained set of prime numbers.

In some embodiments the reverberator parameter determiner 203 further comprises a delay line attenuation filter parameter determiner 503 which is configured to determine attenuation filter coefficients. The attenuation filter coefficients in the delay lines can be configured so that an amount of attenuation happens at each signal recirculation through the delay line so that the desired $RT60(k)$ time is achieved. This is done in a frequency dependent manner to ensure the appropriate rate of decay of signal energy at specified frequencies.

For a frequency bin k, the desired attenuation per signal sample is calculated as $attenuationPerSample(k)$ = -60 / ($f_s$ * $RT60(k)$), where $f_s$ is the sampling rate. The attenuation in decibels for a delay line of length $m_d$ is then $attenuationDb(k) = m_d * attenuationPerSample(k)$.

Furthermore, the attenuation filters are designed as cascade graphic equalizer filters as described in V. Välimäki and J. Liski, "Accurate cascade graphic equalizer," IEEE Signal Process. Lett., vol. 24, no. 2, pp. 176-180, Feb. 2017, for each delay line. The design procedure outlined takes as input a set of command gains at octave bands. There are also methods for a similar graphic EQ structure which can support third octave bands, increasing the number of biquad filters to 31 and providing a better match for detailed target responses such as indicated in J. Rämö, J. Liski, and V. Välimäki, "Third-Octave and Bark Graphic-Equalizer Design with Symmetric Band Filters," Applied Sciences, vol. 10, no. 4, p. 1222, Feb. 2020.

In some embodiments the reverberator parameter determiner 203 comprises a reverberation ratio control filter parameter determiner 505 which can be configured to determine reverberation ratio control filter parameters. The control filter parameters can be designed such that, when the filter is applied to the input signal of the reverberator, the output reverberation will have the desired energy ratio defined by the $RDR(k)$. The input to the design procedure can in some embodiments be the vector of RDR values $RDR(k)$ obtained by the reverberator parameter determiner 203.

The $GEQ_{ratio}$ is configured to match the reverberator spectrum energy to the target spectrum energy. To do this, an estimate of the RDR of the reverberator output and the target RDR is determined. The RDR of the reverberator output can be obtained by rendering a unit impulse through the reverberator using the first reverberator parameters and measuring the energy of the reverberator output and energy of the unit impulse and calculating the ratio of these energies. It is noted that the first echo suppressor 499 is not in use during this determination.

In some embodiments the reverberation ratio control filter parameter determiner 505 is configured to create an input of a unit impulse followed by zeroes of a sufficient length to capture the reverberation tail. In practice, the length of the zero tail is adjusted to equal max(RT60(k)) plus the $t_{pre}$ in samples. The monophonic output signal $s_{rev}(t)$, which is a function of time $t$, can be obtained by summation of the outputs of the feedback network 450.

A long FFT (of length *NFFT*) is calculated over $s_{rev}(t)$ and its absolute value can be obtained as

$$FFA(kk) = \text{abs}(FFT(s_{rev}(t))$$

Here, *kk* are the FFT bin indices. We furthermore obtain the positive half spectral energy density as

$$S(kk) = 1/NFFT * FFA(kk)^2$$

where we add the energy from the negative frequency indices *kk* into the corresponding positive frequency indices *kk*.

The energy of a unit impulse can be calculated or obtained analytically. Denote it as $S_u(kk)$.

In some embodiments the band energies are calculated of both the positive half spectral energy density of the reverberator $S(kk)$ and the positive half spectral energy density of the unit impulse $S_u(kk)$. Band energies can be calculated

as

$$S(k) = \sum_{kk=b_{low}}^{b_{high}} S(kk)$$

where $b_{low}$ and $b_{high}$ are the lowest and highest bin indices belonging to band k, respectively. The band bin indices can be obtained by comparing the frequencies of the bins to the lower and upper frequencies of each band.

The reproduced $RDR_{rev}(k)$ of the reverberator output at the frequency band $k$ is obtained as

$$RDR_{rev}(k) = S(k)/S_u(k)$$

The target linear magnitude response for GEQ$_{ratio}$ can be obtained as

$$rdrFilterTargetResponse(k) \ = \ \text{sqrt}(RDR(k)) \ / \ \text{sqrt}(RDR_{rev}(k))$$

where $RDR(k)$ is the linear target RDR value at band $k$. The target response

$$controlGain(k) \ = \ 20 * \log_{10}(rdrFilterTargetResponse(k))$$

is input as for the graphic equalizer design routine as discussed in the previously cited documents of V. Välimäki and J. Liski, "Accurate cascade graphic equalizer," IEEE Signal Process. Lett., vol. 24, no. 2, pp. 176-180, Feb. 2017 and J. Rämö, J. Liski, and V. Välimäki, "Third-Octave and Bark Graphic-Equalizer Design with Symmetric Band Filters," Applied Sciences, vol. 10, no. 4, p. 1222, Feb. 2020.

The RDR filter target response (control gains for the graphic EQ design routine) can also be obtained directly in the logarithmic domain as

$$controlGain(k) = 10 * \log_{10}\big(RDR(k)\big) - 10 * \log_{10}\big(RDR_{rev}(k)\big)$$

In some embodiments the reverberator parameter determiner 203 comprises a pre-delay line length determiner 507. The pre-delay line length determiner 507 is configured to determine and adjust the length $m_{pre}$ in samples of the pre-delay line based on the input pre-delay time $t_{pre}$. The input pre-delay can be converted to samples and the length of the shortest FN delay line is subtracted from it. This can be set as the length $m_{pre}$. This will cause the first echoes from the FN to occur after time $t_{pre}$. In some other embodiments, the diffuse portion of the FN is set to start after time $t_{pre}$. In this case $m_{pre}$ can be lower and can be set based on an estimate of the time at which the FDN output becomes diffuse and by setting the pre-delay line such that the desired time can be obtained.

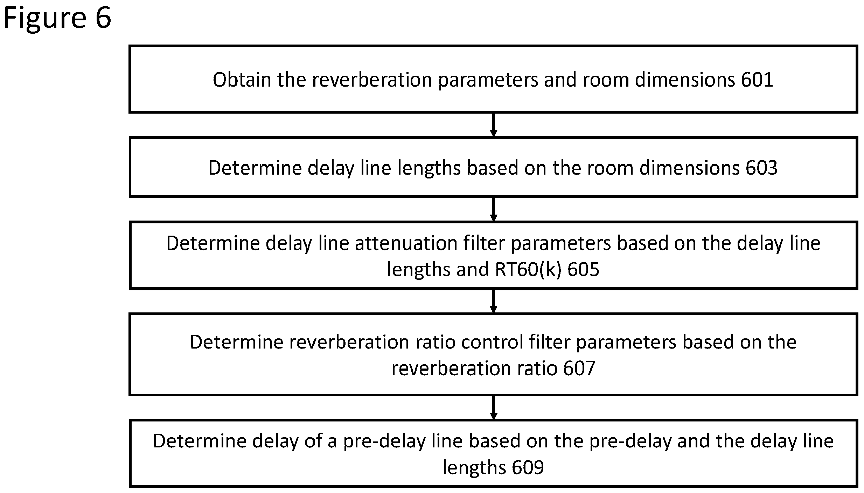

Figure 6 shows example operations of the reverberator parameter determiner 203.

The first operation is obtaining the reverberation parameters and room dimensions as shown by 601.

Then is shown determining delay line lengths based on the room dimensions as shown by 603.

Following this is determining delay line attenuation filter parameters based on the delay line lengths and $RT60(k)$ as shown by 605.

Then determining reverberation ratio control filter parameters based on the reverberation ratio as shown by 607.

After this is determining length of a pre-delay line based on the pre-delay and the delay line lengths as shown by 609.

The first echo suppressor parameter determiner 205 is presented hereafter in further detail. The first echo suppressor parameter determiner 205 can in some embodiments be configured to determine or design the suppression (or inverting) control line gain parameters GEQ$_{ctrl,c}$ as follows.

In a simple example achieving full suppression (cancellation) of first echoes from the FN, GEQ$_{ctrl,c}$ = -GEQ$_d$, wherein indices $c$ and $d$ denote the unique pairings of channels to be summed at the signal combiners 459. This control line gain setting can be used if attenuation filters GEQ$_d$ are scalars and full suppression is desired.

However more generally, the control line gain can instead be set in the range GEQ$_{ctrl,c}$ $\in$ [-GEQ$_d$, 0], where a value of -GEQ$_d$ is full suppression (cancellation), and value of 0 is no suppression. This allows for partial suppression (attenuation) of first echoes.

The principle of suppression gain control can in some embodiments be made frequency dependent. If the desired attenuation filter magnitude response for a control line at frequency bin/index $k$ is $a(k)$, then the corresponding control delay line attenuation filter can have a response $-\gamma a(k)$ where $\gamma \in [0,1]$ controls the amount of suppression and where $\gamma = 1$ corresponds to maximal suppression and $\gamma = 0$ corresponds to no suppression. The control for the number of first echoes to be attenuated can be signaled from an early reflection rendering module (which is discussed later). Generally, this will depend on the order of reflection echo rendering: the more reflection echoes that are rendered by the early reflection rendering module, the more first echoes are to be suppressed from the output of the FN. Generally, the number of first echoes to be suppressed from the output of the FN can be equal to or less than the number of echoes to be rendered by the early reflection module that would otherwise temporally overlap with echoes produced by the FN.

In some embodiments, the number of echoes to be suppressed can be determined based on time regions in an impulse response which contain early reflections. For this purpose, reflection echoes can be synthesized by an early reflection synthesizer and the maximum and minimum time delays where these early reflections occur can be determined. The first echoes of the FN output falling within this same time delay range can then be suppressed.

In some other embodiments, echoes of the FN which interfere with one or more reflection echoes to be synthesized with the early reflection synthesizer can be suppressed. Interfering first echoes can be determined, for example, as those which fall within a predetermined temporal span around time-adjacent reflection echoes.

Alternatively, or in addition, the number of echoes to be attenuated can be signaled as a bitstream parameter. Such an embodiment can utilize analysis of the echo structures of the FN and early reflection renderer performed by the encoder device.

Alternatively, or in addition, the time range(s) of echoes in the FN output to be attenuated can be signaled as a bitstream parameter.

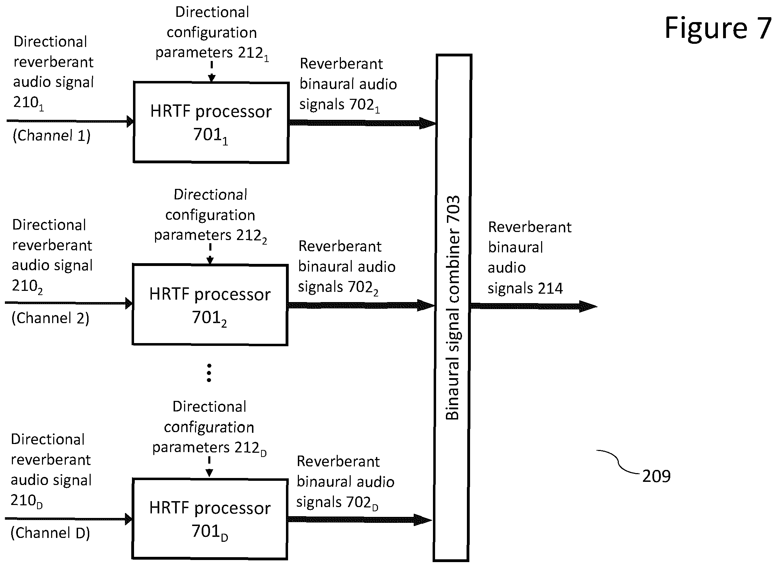

Figure 7 shows schematically the binaural renderer 209 as shown in Figure 2 in further detail.

The input to the binaural renderer 209 is the directional reverberant audio signals $210_d$ $s_{rev}(t, d)$ and the directional configuration parameters $\theta_{ls}(d)$, $\phi_{ls}(d)$ 212. In the example shown in Figure 7 the binaural renderer 209 is organized on a channel-by-channel basis and there are several HRTF processors (one per channel) $701_d$. For example, for a first channel a HRTF processor $701_1$ is configured to receive the directional reverberant audio signal $210_1$ (channel one) and the directional configuration $212_1$ associated with channel one. A second channel a HRTF processor $701_2$ is configured to receive the directional reverberant audio signal $210_2$ (channel two) and the directional configuration $212_2$ associated with channel two. Also shown is a $D$th channel HRTF processor $701_D$ configured to receive the directional reverberant audio signal $210_D$ (channel $D$) and the directional configuration $212_D$ associated with channel $D$. Each of the HRTF processors can comprise an HRTF filter pair $h_{bin}(m, i, d)$, where $m$ is the time index of the filter coefficients, $i = 1, 2$ is the index of the binaural channel, and $d$ is the reverberator output channel index. It would be understood that these reverberator output channels referred here and later can be directional audio signals in general.

The operation of the dth HRTF processor $701_d$ of is as follows. Using the HRTF filter pairs $h_{bin}(m, i, d)$, reverberant binaural audio signals $s_{bin}(t, i, d)$ $702_d$ can be determined for each channel of the directional reverberant audio signals $210_d$ by

$$s_{bin}(t, i, d) = h_{bin}(m, i, d) \otimes s_{rev}(t, d)$$

where $\otimes$ denotes convolution (the filtering may also be performed in the frequency domain in some implementations instead of time-domain convolution).

The reverberant binaural audio signals $s_{bin}(t, i, d)$ $702_d$ can then be passed to a binaural signal combiner 703.

The reverberant binaural audio signals $s_{bin}(t, i, d)$ $702_d$ can then be combined across channels d in the binaural signal combiner 703 by

$$s_{bin}(t, i) = \sum_d s_{bin}(t, i, d)$$

yielding the reverberant binaural signals $s_{bin}(t, i)$ 214 which is the output.

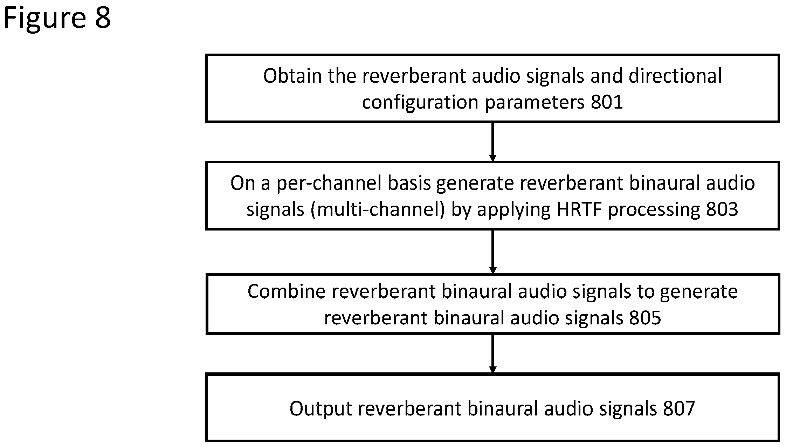

The operations of the binaural renderer is shown in the flow diagram from Figure 8.

The first operation is obtaining the reverberant audio signals and directional configuration parameters as shown by 801.

Then the method can comprise, on a per-channel basis, generating reverberant binaural audio signals by applying HRTF processing as shown by 803.

The method may then comprise combining pairs of reverberant binaural audio signals to generate reverberant binaural audio signals as shown by 805.

Then the reverberant binaural audio signals can be output as shown by step 807.

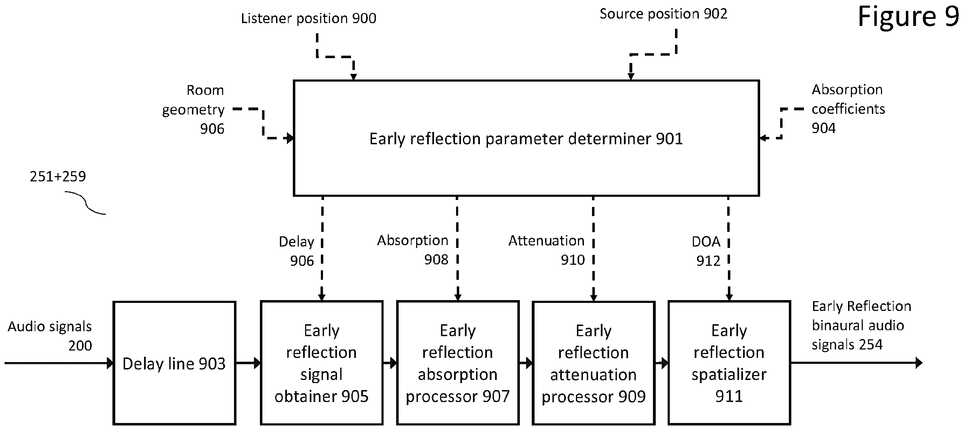

Figure 9 shows an example early reflection renderer 990 suitable for using along with the embodiments as discussed herein. The embodiments aim to reduce interference between the first (early) echoes of the FN output and the synthesized early reflections by the early reflection renderer. There are several ways to calculate or simulate early reflections. As an example, the image source method can be used such as discussed in J. B. Allen and D. A. Berkley, "Image method for efficiently simulating small-room acoustic," J. Acoust. Soc. Am., vol. 65, pp. 943-950, April 1979 and J. Borish. "Extension of the image model to arbitrary polyhedra." The Journal of the Acoustical Society of America 75.6 (1984): 1827-1836.

In the example early reflection renderer 990 shown in Figure 9, an early reflection parameter determiner 901 is configured to receive the inputs of room geometry 906, listener position 900, source position 902, and absorption coefficients 904 and generate control parameters such as delay 906, absorption 908, attenuation 910 and direction of arrival (DOA) 912 and pass these to the processors described hereafter.

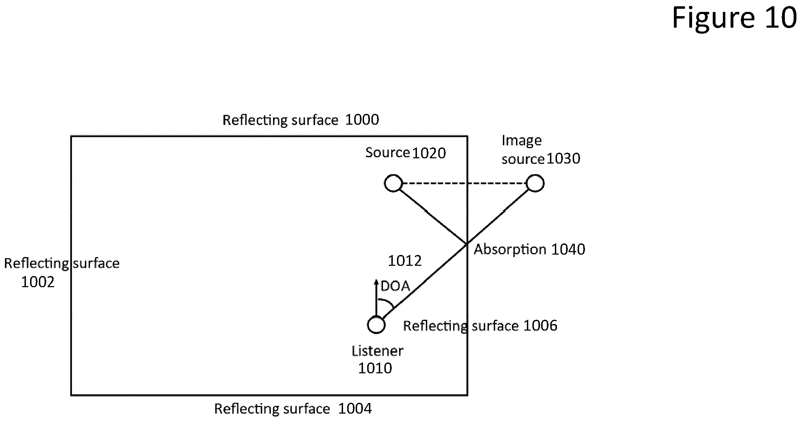

These parameters can be explained with respect to the example shown in Figure 10 where a box or rectangular space is shown with reflecting surfaces 1000, 1002, 1004, 1006. Within the (virtual) acoustic space is the source 1020 and the listener 1010. The directions of an early reflection between the source 1020 and the listener 1010 is shown where on the reflecting surface between the source 1020 and listener 1010 is a reflection and/or absorption point 1040. The mirroring of the source 1020 across the reflecting surface 1006 can be used to establish an image source 1030. The line connecting the image source 1030 to the listener 1010 can then be used to establish the reflection and/or absorption point 1040 and the direction of arrival (DOA) of the reflection with respect to the listener. The delay to be applied to synthesize an early reflection is obtained based on the distance of the reflecting path (path from the image source to the listener which equals the length of the path from the source 1020 to the listener 1010). The absorption $\alpha_i(k)$ corresponds to the reflecting surface 1006 from which this sound trajectory is reflected (the reflection and/or absorption point 1040). The distance attenuation is set proportional to 1/*distance* where *distance* equals the length of the reflection path from the source to the listener. In addition, air absorption can be included in the attenuation of the image source. The DOA of an early reflection is set based on the angle of arrival from the reflection point to the listener.

In some embodiments the input audio signal 920 is first fed into a delay line 903 which buffers audio signal samples and enables picking segments of past samples of the audio signal 920.

The early reflection signal obtainer 905 can receive the output of the delay line 903 and the delay 906 parameter. The early reflection signal obtainer is configured to obtain a past signal sample based on the delay 906 to obtain a delayed signal.

An early reflection absorption processor 907 then can filter the selected past signal sample to apply an equalizer filter to model the absorptions $\alpha_i(k)$ data for the early reflection to obtain delayed and absorption-filtered signal.

An early reflection attenuation processor 909 can then attenuate the delayed and absorption-filtered signal by applying a 1/*distance* attenuation and optionally air absorption to obtain delayed and absorption-filtered and attenuated signal.

Finally, an early reflection spatializer 911 can be configured to spatialize the delayed and absorption-filtered and attenuated signal by HRTF filtering with a left and right HRTF filter corresponding to the desired DOA for this early reflection to obtain a reverberant binaural signal 912 containing the synthesized early reflection portion. In some situations, the early reflection spatializer can be the binauralizer.

There are various ways to determine the image source parameters within the early reflection parameter determiner 901. In the image source method, the sound source position is mirrored with respect to each reflecting surface of the room geometry to obtain image sources. In the example shown in Figure 10, the mirroring is performed with regard to the rightmost reflecting surface 1006. The image source 1030 is located on a line perpendicular to reflecting surface 1006, at the same distance from it as the source 1020. A path from the image source 1020 to the listener 1010 indicates the distance traveled by the reflection. First order reflections reflect from a single wall whereas higher order reflections reflect from more than one wall. Higher order reflections can be obtained by using higher-order image sources which are mirrored by each of the reflecting surfaces in turn.

In some circumstances the output of the determiner is a list of image source positions such as [$\mathbf{r}_0$, $\mathbf{r}_1$, ..., $\mathbf{r}_l$, $\mathbf{r}_{1,1}$, ..., $\mathbf{r}_{1,l}$, ..., $\mathbf{r}_{i,i,...}$], where $\mathbf{r}_{i,i,...} = [x_{i,i,...}, y_{i,i,...}, z_{i,i,...}]$ are the coordinates an image source that in each order of reflection has been reflected by the ith subsequent surface.

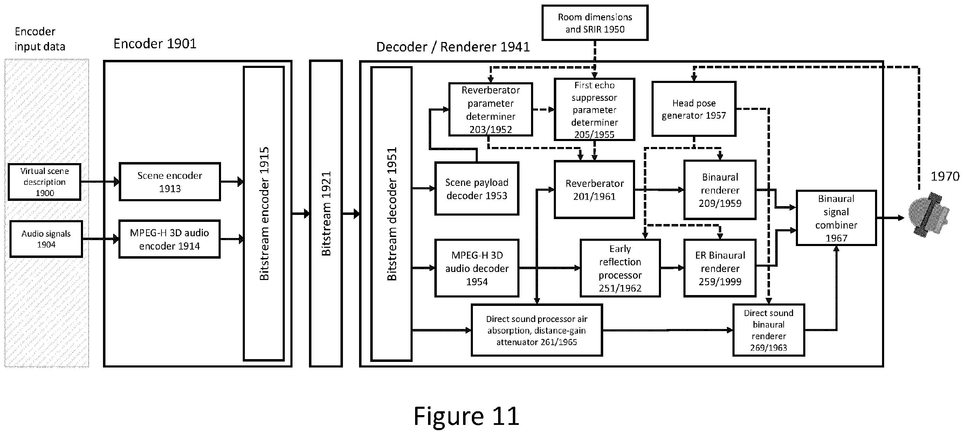

Figure 11 shows schematically an example system where the embodiments are implemented in an encoder device 1901 which performs part of the functionality; writes data into a bitstream 1921 and transmits that for a renderer device 1941, which decodes the bitstream, performs reverberator processing according to the embodiments and outputs audio for headphone listening.

The encoder side 1901 of Figure 11 can be performed on content creator computers and/or network server computers. The output of the encoder is the bitstream 1921 which is made available for downloading or streaming. The decoder/renderer 1941 functionality runs on an end-user-device, which can be a mobile device, personal computer, sound bar, tablet computer, car media system, home HiFi or theatre system, head mounted display for AR or VR, smart watch, or any suitable system for audio consumption.

The encoder 1901 is configured to receive the virtual scene description 1900 and the audio signals 1904. The virtual scene description 1900 can be provided in the MPEG-I encoder input format (EIF) or in another suitable format. Generally, the virtual scene description contains an acoustically relevant description of the contents of the virtual scene, and contains, for example, the scene geometry as a mesh or as voxels, acoustic materials, acoustic environments with reverberation parameters, positions of sound sources, and other audio element related parameters such as whether reverberation is to be rendered for an audio element or not. The encoder 1901 in some embodiments comprises a scene and reverberation payload encoder 1913 configured to generate reverberation parameters.

The encoder 1901 further comprises a MPEG-H 3D audio encoder 1914 configured to obtain the audio signals 1904 and MPEG-H encode them and pass them to a bitstream encoder 1915.

The encoder 1901 furthermore in some embodiments comprises a bitstream encoder 1915 which is configured to receive the output of the scene and reverberation payload encoder 1913 and the encoded audio signals from the MPEG-H encoder 1914 and generate the bitstream 1921 which can be passed to the bitstream decoder 1941. The bitstream 1921 in some embodiments can be streamed to end-user devices or made available for download or stored.

The decoder 1941 in some embodiments comprises a bitstream decoder 1951 configured to decode the bitstream.

The decoder 1941 further can comprise a scene payload decoder 1953 configured to obtain the encoded reverberation parameters and decode these in an opposite or inverse operation to the reverberation payload encoder 1913.

The reverberator parameter determiner 203/1952 is configured to receive the decoded reverberation parameters and room dimensions and spatial room impulse response (SRIR) 1950 information and generate the reverberator control parameters discussed herein. Note that in some embodiments no SRIR is received but reverberator parameters are obtained from the scene payload decoder 1953.

The first echo suppressor parameter determiner 205/1955 is configured to receive the generated reverberator control parameters and the room dimensions and optionally SRIR 1950 and generate the control delay line and control line gain filter parameters in the manner as discussed above.

Furthermore, the head pose generator 1957 receives information from a head mounted device 1970 or similar and generates head pose information or parameters which can be passed to the binaural renderer 209/1959, the early reflection renderer 990/1962 and the direct sound binaural renderer 1963.

The decoder 1941 comprise MPEG-H 3D audio decoder 1954 which is configured to decode the audio signals and pass them to the reverberators 201/1961 and direct sound processing 1965.

The decoder 1941 furthermore comprises reverberators 201/1961 configured to implement a suitable reverberation of the audio signals from the MPEG-H 3D audio decoder 1954.

The output of the reverberators 201/1961 is configured to output reverberated audio based on the reverberator parameters to a binaural renderer 209/1959.

The decoder furthermore comprises an early reflection renderer 990/1962 configured to obtain the output of the MPEG-H 3D audio decoder 1954 and generate early reflections as described above and pass these to an early reflection binaural renderer 1999.

The decoder further comprises a binaural renderer 209/1959 configured to generate binaural reverberant audio signals from the output of the reverberators 201/1961.

The decoder further comprises an early reflection (ER) binaural renderer 1999 configured to generate binaural early reflection audio signals from the output of the early reflection renderer 990/1962.

Additionally the decoder/renderer 1941 comprises a direct sound processor 1965 which is configured to receive the decoded audio signals and configured to implement any direct sound processing such as air absorption and distance-gain attenuation and which can be passed to a direct sound binaural renderer 1963 which with the head orientation determination (from a suitable sensor) can generate the direct sound component which with the reverberant component is passed to a binaural signal combiner 1967. The binaural signal combiner 1967 is configured to combine the direct, early reflection, and reverberant parts to generate a suitable output (for example for headphone reproduction).

Furthermore, in some embodiments the decoder comprises a head orientation determiner which passes the head orientation information to the head pose generator 1957.

As an alternative to transmitting reverberation parameters from the encoder to the renderer it is possible in some embodiments to transmit reverberator parameters in the bitstream. Reverberator parameters refer to the FDN parameters such as delay line lengths, attenuation filters, reverberation ratio control filters, and so on.

In some embodiments the assignment of reverberator outputs to loudspeaker channels happens during configuration of the reverberator. The assignment can be stored during configuration and provided to the reverberant signal router.

In some embodiments, the output is a multichannel loudspeaker setup (such as 5.1 or 7.1+4 multichannel loudspeaker setup). In that case, the processing proposed in Figure 2 can be modified by using the directions of the actual loudspeakers as the directional configuration $\theta_{ls}(d)$, $\phi_{ls}(d)$, and omitting the binaural renderer, and reproducing the reverberant audio signals from the corresponding loudspeakers of the loudspeaker setup. Referring to Figure 15, in the case of loudspeaker output, instead of binaural renderer 209/1959 there will be loudspeaker renderer (or panner) which in the simplest case will just pass through the loudspeaker signals to a loudspeaker signal combiner which will replace the binaural signal combiner 1967. Correspondingly, the direct sound part and early reflection part are spatialized with a panner such as VBAP implemented instead of the binaural processors.

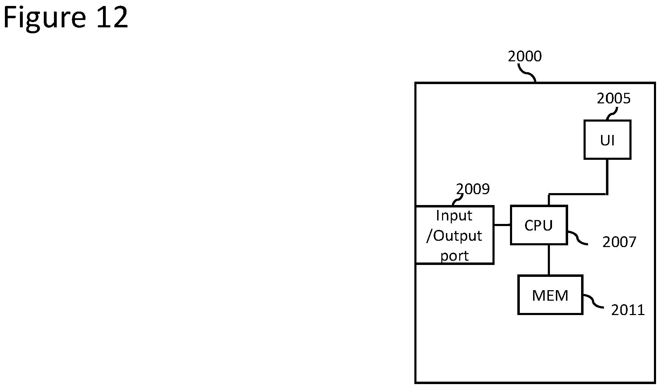

With respect to Figure 12 an example electronic device which may be used as any of the apparatus parts of the system as described above. The device may be any suitable electronics device or apparatus. For example, in some embodiments the device 2000 is a mobile device, user equipment, tablet computer, computer, audio playback apparatus, etc. The device may for example be configured to implement the encoder or the renderer or any functional block as described above.

In some embodiments the device 2000 comprises at least one processor or central processing unit 2007. The processor 2007 can be configured to execute various program codes such as the methods described herein.

In some embodiments the device 2000 comprises a memory 2011. In some embodiments the at least one processor 2007 is coupled to the memory 2011. The memory 2011 can be any suitable storage means. In some embodiments the memory 2011 comprises a program code section for storing program codes implementable upon the processor 2007. Furthermore, in some embodiments the memory 2011 can further comprise a stored data section for storing data, for example data that has been processed or to be processed in accordance with the embodiments as described herein. The implemented program code stored within the program code section and the data stored within the stored data section can be retrieved by the processor 2007 whenever needed via the memory-processor coupling.

In some embodiments the device 2000 comprises a user interface 2005. The user interface 2005 can be coupled in some embodiments to the processor 2007. In some embodiments the processor 2007 can control the operation of the user interface 2005 and receive inputs from the user interface 2005. In some embodiments the user interface 2005 can enable a user to input commands to the device 2000, for example via a keypad. In some embodiments the user interface 2005 can enable the user to obtain information from the device 2000. For example, the user interface 2005 may comprise a display configured to display information from the device 2000 to the user. The user interface 2005 can in some embodiments comprise a touch screen or touch interface capable of both enabling information to be entered to the device 2000 and further displaying information to the user of the device 2000. In some embodiments the user interface 2005 may be the user interface for communicating.

In some embodiments the device 2000 comprises an input/output port 2009. The input/output port 2009 in some embodiments comprises a transceiver. The transceiver in such embodiments can be coupled to the processor 2007 and configured to enable a communication with other apparatus or electronic devices, for example via a wireless communications network. The transceiver or any suitable transceiver or transmitter and/or receiver means can in some embodiments be configured to communicate with other electronic devices or apparatus via a wire or wired coupling.

The transceiver can communicate with further apparatus by any suitable known communications protocol. For example, in some embodiments the transceiver can use a suitable universal mobile telecommunications system (UMTS) protocol, a wireless local area network (WLAN) protocol such as for example IEEE 802.X, a suitable short-range radio frequency communication protocol such as Bluetooth, or infrared data communication pathway (IRDA).

The input/output port 2009 may be configured to receive the signals.

In some embodiments the device 2000 may be employed as at least part of the renderer. The input/output port 2009 may be coupled to headphones (which may be a headtracked or a non-tracked headphones) or similar.

In general, the various embodiments of the invention may be implemented in hardware or special purpose circuits, software, logic or any combination thereof. For example, some aspects may be implemented in hardware, while other aspects may be implemented in firmware or software which may be executed by a controller, microprocessor or other computing device, although the invention is not limited thereto. While various aspects of the invention may be illustrated and described as block diagrams, flow charts, or using some other pictorial representation, it is well understood that these blocks, apparatus, systems, techniques or methods described herein may be implemented in, as non-limiting examples, hardware, software, firmware, special purpose circuits or logic, general purpose hardware or controller or other computing devices, or some combination thereof.

The embodiments of this invention may be implemented by computer software executable by a data processor of the mobile device, such as in the processor entity, or by hardware, or by a combination of software and hardware. Further in this regard it should be noted that any blocks of the logic flow as in the Figures may represent program steps, or interconnected logic circuits, blocks and functions, or a combination of program steps and logic circuits, blocks and functions. The software may be stored on such physical media as memory chips, or memory blocks implemented within the processor, magnetic media such as hard disk or floppy disks, and optical media such as for example DVD and the data variants thereof, CD.

The memory may be of any type suitable to the local technical environment and may be implemented using any suitable data storage technology, such as semiconductor-based memory devices, magnetic memory devices and systems, optical memory devices and systems, fixed memory and removable memory. The data processors may be of any type suitable to the local technical environment, and may include one or more of general-purpose computers, special purpose computers, microprocessors, digital signal processors (DSPs), application specific integrated circuits (ASIC), gate level circuits and processors based on multi-core processor architecture, as non-limiting examples.

Embodiments of the inventions may be practiced in various components such as integrated circuit modules. The design of integrated circuits is by and large a highly automated process. Complex and powerful software tools are available for converting a logic level design into a semiconductor circuit design ready to be etched and formed on a semiconductor substrate.

Programs, such as those provided by Synopsys, Inc. of Mountain View, California and Cadence Design, of San Jose, California automatically route conductors and locate components on a semiconductor chip using well established rules of design as well as libraries of pre-stored design modules. Once the design for a semiconductor circuit has been completed, the resultant design, in a standardized electronic format (e.g., Opus, GDSII, or the like) may be transmitted to a semiconductor fabrication facility or "fab" for fabrication.

The foregoing description has provided by way of exemplary and non-limiting examples a full and informative description of the exemplary embodiment of this invention. However, various modifications and adaptations may become apparent to those skilled in the relevant arts in view of the foregoing description, when read in conjunction with the accompanying drawings and the appended claims. However, all such and similar modifications of the teachings of this invention will still fall within the scope of this invention as defined in the appended claims.

## Claims

1. An apparatus for applying reverberation to at least one audio signal, the apparatus comprising means for:

   obtaining the at least one audio signal;
   obtaining at least one reverberation parameter;
   controlling a digital reverberator based on the at least one reverberation parameter;
   providing at least one control line comprising a delay line and a gain filter, the at least one control line using the at least one reverberation parameter to generate an output from the at least one control line; and
   generating at least one reverberated audio signal based on at least one output of the at least one digital reverberator and the generated output from the at least one control line, wherein at least a portion of late reverberation in the generated at least one reverberated audio signal interfering with at least one reflection echo is substantially attenuated.

2. The apparatus as claimed in claim 1, wherein the means for obtaining the at least one reverberation parameter comprising means for obtaining at least one reverberation time.

3. The apparatus as claimed in claim 2, wherein the means for controlling the digital reverberator based on the at least one reverberation parameter comprises means for applying at least one delay line to the at least one audio signal to generate at least two echoes.

4. The apparatus as claimed in claim 3, wherein the means for providing the at least one control line comprises means for providing at least one control echo.

5. The apparatus as claimed in claim 4, wherein the means for generating the at least one reverberated audio signal comprises means for at least one of:

   generating the at least one reverberated audio signal based on a combination of at least one audio signal containing the at least two echoes from the at least one output of the digital reverberator and at least one audio signal containing the at least one control echo from the at least one output of the at least one control line respectively; and
   providing the at least one control echo to at least partially suppress a first echo of the at least two echoes such that the at least one reverberated audio signal comprises reverberations which do not interfere with the at least one reflection echoes.

6. The apparatus as claimed in claim 1, wherein the means for obtaining the at least one reverberation parameter comprises means for obtaining the at least one reverberation parameter based on at least one dimension parameter associated with a virtual acoustic space within which the audio signal is being rendered.

7. The apparatus as claimed in claim 1, wherein the means for controlling the digital reverberator based on the at least one reverberation parameter comprises means for at least one of:

   controlling at least one feedback attenuation filter; and
   controlling a feedback matrix configured to feedback at least one output of the digital reverberator to at least one input of the digital reverberator.

8. The apparatus as claimed in claim 1, wherein the at least one control line is a first number of control lines and the digital reverberator comprises a second number of delay lines.

9. The apparatus as claimed in claim 8, wherein the first number is less than or equal to the second number.

10. The apparatus as claimed in claim 1, wherein at least the portion of late reverberation is at least an early portion of the late reverberation.

11. A method for applying reverberation to at least one audio signal, the method comprising:

   obtaining the at least one audio signal;
   obtaining at least one reverberation parameter;
   controlling a digital reverberator based on the at least one reverberation parameter;
   providing at least one control line comprising a delay line and a gain filter, the at least one control line using the at least one reverberation parameter to generate an output from the at least one control line; and
   generating at least one reverberated audio signal based on at least one output of the at least one digital reverberator and the generated output from the at least one control line, wherein at least a portion of late reverberation in the generated at least one reverberated audio signal interfering with at least one reflection echo is substantially attenuated.

12. The method as claimed in claim 11, wherein obtaining the at least one reverberation parameter comprises obtaining at least one reverberation time.

13. The method as claimed in claim 12, wherein controlling the digital reverberator based on the at least one reverberation parameter comprises applying at least one delay line to the at least one audio signal to generate at least two echoes.

14. The method as claimed in claim 13, wherein providing the at least one control line comprises providing at least one control echo.

15. The method as claimed in claim 14, wherein generating the at least one reverberated audio signal comprises at least one of:

   generating the at least one reverberated audio signal based on a combination of at least one audio signal containing the at least two echoes from the at least one output of the digital reverberator and at least one audio signal containing the at least one control echo from the at least one output of the at least one control line respectively; and
   providing the at least one control echo to at least partially suppress a first echo of the at least two echoes such that the at least one reverberated audio signal comprises reverberations which do not interfere with the at least one reflection echoes.

# Figure 1

Magnitude

101 103 105

Direct sound

Directional
early
reflections

Diffuse late
reverberation

Time (s)

d1(t) 102

d2(t) 104

Figure 2

Direct Audio (D) processor 261 → D audio signals 260 → D Binaural Renderer 269 → D Binaural audio signals 264

Reflection (R) processor 251 → R audio signals 250 → R Binaural Renderer 259 → Early Reflection Binaural audio signals 254

Directional configuration parameters 212

Audio signal 200

Reverberator 201 → Reverberant audio signals 210 → Binaural Renderer 209 → Reverberant Binaural audio signals 214

Reverberator parameters 204

First echo suppressor parameters 208

Reverberation parameters 202

Reverberator Parameter determiner 203 → Reverberator parameters 206 → First echo suppressor parameter determiner 205

290

299

**Figure 3**

```
┌─────────────────────────────────────────────────────────┐
│   Obtain the audio signals, directional configuration    │
│   parameters and reverberation parameters 301            │
└─────────────────────────────────────────────────────────┘
                          │
                          ▼
┌─────────────────────────────────────────────────────────┐
│   Determine the reverberator configuration from the      │
│   reverberation (and directional configuration)          │
│   parameters 303                                         │
└─────────────────────────────────────────────────────────┘
                          │
                          ▼
┌─────────────────────────────────────────────────────────┐
│   Determine the first echo suppressor configuration      │
│   from the reverberator parameters input 305             │
└─────────────────────────────────────────────────────────┘
                          │
                          ▼
┌─────────────────────────────────────────────────────────┐
│   Generate reverberated audio based on the audio signal  │
│   and the configured reverberator 307                    │
└─────────────────────────────────────────────────────────┘
                          │
                          ▼
┌─────────────────────────────────────────────────────────┐
│   Render reverberant binaural signals using reverberated │
│   audio and directional configuration parameters 309     │
└─────────────────────────────────────────────────────────┘
                          │
                          ▼
┌─────────────────────────────────────────────────────────┐
│   Output reverberant binaural signals 311                │
└─────────────────────────────────────────────────────────┘
```

Figure 4

EP 4 462 423 A1

# Figure 5

Reverberation parameters/ room dimensions 202

## Reverberator parameter determiner 203

Delay line length determiner 501

Delay line attenuation filter parameters determiner 503

Reverberation ratio control filter parameter determiner 505

Pre-delay line length determiner 507

Reverberator parameters 204:
delay line length;
delay line attenuation filter;
reverberation ratio control filter;
pre-delay line length; and
feedback matrix coefficients.

203

# Figure 6

Obtain the reverberation parameters and room dimensions 601

Determine delay line lengths based on the room dimensions 603

Determine delay line attenuation filter parameters based on the delay line lengths and RT60(k) 605

Determine reverberation ratio control filter parameters based on the reverberation ratio 607

Determine delay of a pre-delay line based on the pre-delay and the delay line lengths 609

EP 4 462 423 A1

EP 4 462 423 A1

Figure 7

Directional reverberant audio signal 210₁ (Channel 1) →

Directional configuration parameters 212₁ →

HRTF processor 701₁ → Reverberant binaural audio signals 702₁ →

Directional reverberant audio signal 210₂ (Channel 2) →

Directional configuration parameters 212₂ →

HRTF processor 701₂ → Reverberant binaural audio signals 702₂ →

Directional reverberant audio signal 210_D (Channel D) →

Directional configuration parameters 212_D →

HRTF processor 701_D → Reverberant binaural audio signals 702_D →

Binaural signal combiner 703 → Reverberant binaural audio signals 214

209

# Figure 8

```
┌─────────────────────────────────────────────────────────┐
│   Obtain the reverberant audio signals and directional   │
│         configuration parameters 801                     │
└─────────────────────────────────────────────────────────┘
                          │
                          ▼
┌─────────────────────────────────────────────────────────┐
│  On a per-channel basis generate reverberant binaural    │
│   audio signals (multi-channel) by applying HRTF         │
│                 processing 803                            │
└─────────────────────────────────────────────────────────┘
                          │
                          ▼
┌─────────────────────────────────────────────────────────┐
│  Combine reverberant binaural audio signals to generate  │
│        reverberant binaural audio signals 805            │
└─────────────────────────────────────────────────────────┘
                          │
                          ▼
┌─────────────────────────────────────────────────────────┐
│     Output reverberant binaural audio signals 807        │
└─────────────────────────────────────────────────────────┘
```

Figure 9

EP 4 462 423 A1

EP 4 462 423 A1

Figure 10

Reflecting surface 1000

Source 1020

Image source 1030

Reflecting surface 1002

Absorption 1040

1012

DOA

Reflecting surface 1006

Listener 1010

Reflecting surface 1004

Figure 11

# Figure 12

| | Europäisches Patentamt European Patent Office Office européen des brevets | **EUROPEAN SEARCH REPORT** | **Application Number** EP 24 16 9616 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Meyer-Kahlen Nils ET AL: "FADE-IN CONTROL FOR FEEDBACK DELAY NETWORKS", , 1 September 2020 (2020-09-01), pages 227-233, XP093186921, Retrieved from the Internet: URL:https://dafx2020.mdw.ac.at/proceedings /papers/DAFx2020_paper_47.pdf [retrieved on 2024-07-17] | 1-15 | INV. G10K15/12 H04S7/00 |
| Y | * abstract * * figures 1-10 * * pages 227-231 * | 2-10, 12-15 | |
| X | WO 2022/223874 A1 (NOKIA TECHNOLOGIES OY [FI]) 27 October 2022 (2022-10-27) | 1,11 | |
| Y | * abstract * * figures 1-10 * * pages 15-33 * | 2-10, 12-15 | |
| A | AARON B GREENBLATT ET AL: "A hybrid reverberation crossfading technique", ACOUSTICS SPEECH AND SIGNAL PROCESSING (ICASSP), 2010 IEEE INTERNATIONAL CONFERENCE ON, IEEE, PISCATAWAY, NJ, USA, 14 March 2010 (2010-03-14), pages 429-432, XP031697678, ISBN: 978-1-4244-4295-9 * abstract * * figures 1-6 * * pages 429-432 * | 1-15 | **TECHNICAL FIELDS SEARCHED (IPC)** G10K H04S |

The present search report has been drawn up for all claims

| Place of search | Date of completion of the search | Examiner |
|---|---|---|
| The Hague | 22 July 2024 | Meyer, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 462 423 A1**

## ANNEX TO THE EUROPEAN SEARCH REPORT
## ON EUROPEAN PATENT APPLICATION NO.

EP 24 16 9616

This annex lists the patent family members relating to the patent documents cited in the above-mentioned European search report.
The members are as contained in the European Patent Office EDP file on
The European Patent Office is in no way liable for these particulars which are merely given for the purpose of information.

22-07-2024

| Patent document cited in search report | | Publication date | Patent family member(s) | | Publication date |
|---|---|---|---|---|---|
| WO 2022223874 | A1 | 27-10-2022 | CN 117242796 A | | 15-12-2023 |
| | | | EP 4327570 A1 | | 28-02-2024 |
| | | | US 2024196159 A1 | | 13-06-2024 |
| | | | WO 2022223874 A1 | | 27-10-2022 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- *IEEE Signal Processing Letters,* September 1997, vol. 4 (9
- **V. VÄLIMÄKI ; J. LISKI.** Accurate cascade graphic equalizer. *IEEE Signal Process. Lett.,* February 2017, vol. 24 (2), 176-180
- **J. RÄMÖ ; J. LISKI ; V. VÄLIMÄKI.** Third-Octave and Bark Graphic-Equalizer Design with Symmetric Band Filters. *Applied Sciences,* February 2020, vol. 10 (4), 1222
- **J. RÄMÖ ; J. LISKI ; V. VÄLIMÄKI.** Third-Octave and Bark Graphic-Equalizer Design with Symmetric Band Filters. *Applied Sciences,* February 2020, vol. 10 (4), 1222
- **J. B. ALLEN ; D. A. BERKLEY.** Image method for efficiently simulating small-room acoustic. *J. Acoust. Soc. Am.,* April 1979, vol. 65
- **J. BORISH.** Extension of the image model to arbitrary polyhedra. *The Journal of the Acoustical Society of America,* 1984, vol. 75 (6), 1827-1836